(19) Europäisches Patentamt
European Patent Office
Office européen des brevets

(11) Veröffentlichungsnummer: **0 271 010 B1**

# (12) EUROPÄISCHE PATENTSCHRIFT

(45) Veröffentlichungstag der Patentschrift: **11.12.91**

(51) Int. Cl.$^5$: **C08F 220/36**, C08F 212/14, C08F 222/22, G03F 7/00

(21) Anmeldenummer: **87117943.8**

(22) Anmeldetag: **04.12.87**

## (54) Copolymerisate mit 0-Nitrocarbinolestergruppierungen und deren Verwendung.

(30) Priorität: **10.12.86 DE 3642184**

(43) Veröffentlichungstag der Anmeldung:
**15.06.88 Patentblatt 88/24**

(45) Bekanntmachung des Hinweises auf die Patenterteilung:
**11.12.91 Patentblatt 91/50**

(84) Benannte Vertragsstaaten:
**AT BE CH DE FR GB IT LI NL**

(56) Entgegenhaltungen:
**DE-A- 2 800 905**
**DE-A- 2 922 746**
**DE-A- 3 415 791**
**DE-C- 2 150 691**

**CHEMICAL ABSTRACTS, Band 107, Nr. 14, 5. Oktober 1987, Columbus, Ohio, USA H.FUJIWARA et al. "Styrenated poly(vinylphenol)" Seite 31, Zusammenfassung-Nr. 116 418z**

**POLYMER, Band 24, Nr. 7, August 1983, Butterworth et Co., Guildford UK J.M.J. FRECHET et al. "Poly (p-tert-Butoxycarbonyloxy- styrene): A convenient precursor to p.-hydroxystyrene resins" Seiten 995-1000**

(73) Patentinhaber: **BASF Aktiengesellschaft**
**Carl-Bosch-Strasse 38**
**W-6700 Ludwigshafen(DE)**

(72) Erfinder: **Schwalm, Reinhold, Dr.**
**Am Huettenwingert 53**
**W-6706 Wachenheim(DE)**
Erfinder: **Binder, Horst**
**Haendelstrasse 3-5**
**W-6840 Lampertheim(DE)**

**EP 0 271 010 B1**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Beschreibung

Die Erfindung betrifft Copolymerisate mit o-Nitrocarbinolestergruppierungen sowie deren Verwendung als lichtempfindliche Beschichtungsmaterialien für Photoresiste, zur Herstellung von Halbleiterbauelementen. Flachdruckplatten und als Photoätzgrund, insbesondere Copolymerisate, die O-substituierte p-Hydroxystyroleinheiten einpolymerisiert enthalten und daraus hergestellte positiv arbeitende Photoresiste, die nach der Belichtung mit kurzwelligem UV-Licht, z.B. im Wellenlängenbereich zwischen 300 nm und 190 nm, mit einem alkalischen Lösungsmittel ausgewaschen werden können, ausreichend stabil gegen Plasmaätzprozesse sind und insbesondere für die Photolithographie verwendet werden können.

In lithographischen Verfahren, z.B. zur Herstellung von Halbleiterbauelementen, werden zahlreiche lichtempfindliche Resistmaterialien verwendet. Diese Materialien werden in den belichteten Bereichen in ihren Löslichkeitseigenschaften so verändert, daß eine Löslichkeitsdifferenzierung zwischen belichteten und unbelichteten Bereichen resultiert. Bei positiv arbeitenden Resisten zeigen die belichteten Bereiche eine bessere Löslichkeit in einem geeigneten Lösungsmittel als die nicht belichteten Bereiche. Die konventionellen positiv arbeitenden Photoresiste sind überwiegend Systeme aus einer photounempfindlichen, alkalilöslichen Matrix auf Basis von Novolaken und einer photoempfindlichen Komponente, die als Löslichkeitsinhibitor wirkt und durch die Belichtung in alkalilösliche Produkte umgewandelt wird, so daß die gesamten belichteten Bereiche in dem alkalischen Entwickler löslich werden. Diese Systeme haben sich zwar als sehr brauchbar erwiesen, weisen aber bei Belichtung mit kurzwelligem UV-Licht Nachteile auf, da die Novolak-Matrix in dem Wellenlängenbereich kleiner 300 nm stark absorbiert und damit die Belichtung im relevanten Schichtdickenbereich größer 0,5 µm unzweckmäßig ist.

Photosensitive Polymere als Resiste für den kurzwelligen UV-Bereich sind z.B. Poly-(methylmethacrylat), Copolymere aus Methylmethacrylat und Indenon (J. Vac. Sci. Techn., 19, 1333, 1981), sowie aus Methylmethacrylat und 3-Oximino-2-butanon als photoaktiver Komponente (z.B. US 4 382 120 und US 4 343 889).

Ebenfalls bekannt sind Zweikomponentensysteme aus einer Poly-(methylmethacrylat-co-methacrylsäure)-Matrix und o-Nitrobenzylestern, z.B. Estern der Cholsäure, als Löslichkeitsinhibitoren (vgl. z.B. DE-A 34 15 791).

Einkomponentenresiste aus o-Nitrobenzylcarbinolestergruppierungen enthaltenden Copolymeren sind z.B. in DE-A 21 50 691 und DE-A 29 22 746 beschrieben.

Während die Stabilität der Resiste für den kurzwelligen UV-Bereich gegen Naßätzverfahren ausreichend ist, ist dagegen ihre Stabilität gegen fluor- und chlorhaltige Plasmen, die gegebenenfalls noch Sauerstoff enthalten, wie sie zur Ätzung bei der Halbleiterbauelementeherstellung angewendet werden, begrenzt und verbesserungsbedürftig.

Aufgabe der vorliegenden Erfindung ist es, neue Copolymerisate und deren Verwendung, insbesondere daraus hergestellte positiv arbeitende Resiste aufzuzeigen, die insbesondere die Herstellung von Resistmustern gestatten, hohe thermische Stabilität, Resistenz gegenüber fluor- und chlorhaltigen Plasmen besitzen und nach der Belichtung mit kurzwelligem UV-Licht mit alkalischen Lösungsmitteln auswaschbar sind.

Überraschenderweise wurde gefunden, daß dieses Ziel mit Copolymerisaten bestimmter Zusammensetzung, die sowohl o-Nitrocarbinolestergruppierungen als auch O-substituierte p-Hydroxystyroleinheiten einpolymerisiert enthalten, erreicht werden kann.

Gegenstand der vorliegenden Erfindung sind Copolymerisate, die einpolymerisiert enthalten

(a) 5 bis 50 Mol.% mindestens einer Verbindung der allgemeinen Formel (I)

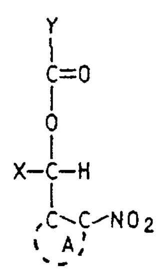

(I)

worin A für ein aromatisches oder heteroaromatisches, gegebenenfalls substituiertes Ringsystem mit 5 bis 14 Ringgliedern,

X für Wasserstoff, einen Alkylrest mit 1 bis 8 Kohlenstoffatomen, einen gegebenenfalls substituierten Aryl- oder Aralkylrest und

Y für einen ethylenisch ungesättigten Rest mit 2 bis 6 Kohlenstoffatomen stehen,

b) 95 bis 50 Mol.% mindestens einer Verbindung der allgemeinen Formel (II)

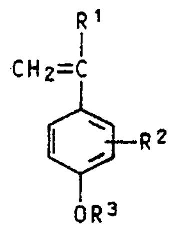

(II)

worin

$R^1$ für Wasserstoff oder eine Methylgruppe,

$R^2$ für Wasserstoff, Halogen oder eine Alkylgruppe mit 1 bis 6 Kohlenstoffatomen,

$R^3$ für Wasserstoff, eine Alkylgruppe mit 1 bis 6 Kohlenstoffatomen, eine Acetyl-, Benzoyl-, $C_1$- bis $C_6$-Alkylsilyl-, $C_1$- bis $C_6$-Alkoxisilyl- oder eine tert.-Butoxicarbonylgruppe

stehen,

c) 0 bis 30 Mol.% einer oder mehrerer weiterer von (a) und (b) verschiedener olefinisch ungesättigter, copolymerisierbarer organischer Verbindungen, deren Homopolymerisate im Wellenlängenbereich zwischen 250 und 400 nm transparent sind,

mit der Maßgabe, daß die Summe der unter a) bis c) genannten Prozentzahlen 100 ist.

Bevorzugt sind solche Copolymerisate, in denen der Rest Y in der allgemeinen Formel (I) für einen der Reste

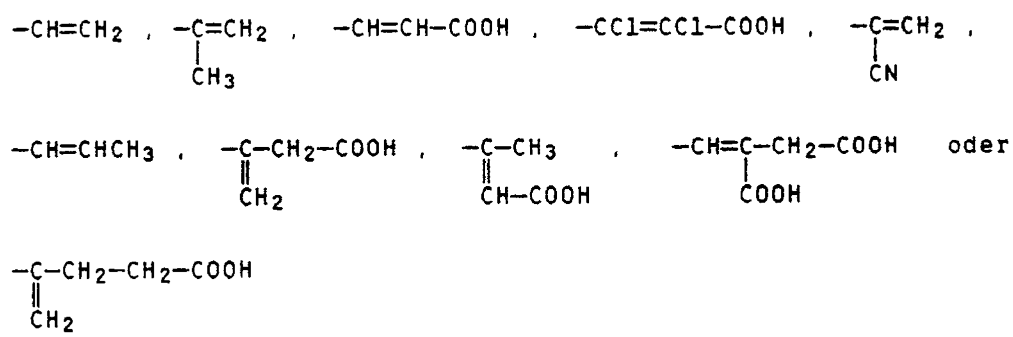

steht.

Erfindungsgemäß erfolgt die Herstellung dieser Copolymerisate in der Weise, daß die unter a) bis c) genannten Verbindungen in Gegenwart radikalliefernder Initiatoren polymerisiert werden, mit der Maßgabe daß $R^3$ der Komponente b) für eine Alkylgruppe mit 1 bis 6 Kohlenstoffatomen, eine Acetyl-, Benzoyl-, $C_1$- bis $C_6$-Alkylsilyl-, $C_1$- bis $C_6$-Alkoxisilyl-oder eine tert.-Butoxicarbonylgruppe steht und das erhaltene Copolymerisat gegebenfalls in das Copolymerisat mit $R^3$ = H überführt wird.

Gegenstand der Erfindung sind insbesondere auch wäßrig-alkalisch auswaschbare Photoresiste, die die erfindungsgemäßen Copolymerisate enthalten, sowie Verfahren zur Herstellung von Halbleiterbauelementen auf Basis dieser Copolymerisate. Ferner ist die Verwendung der erfindungsgemäßen Copolymerisate in lichtempfindlichen Beschichtungsmaterialien und zur Herstellung von Trockenresisten und Druckplatten Gegenstand der vorliegenden Erfindung.

Die erfindungsgemäßen lichtempfindlichen Copolymerisate, die o-Nitrocarbinolestergruppierungen und O-substituierte p-Hydroxystyroleinheiten enthalten, können nach der bildmäßigen Belichtung und ganz oder teilweiser Überführung der Gruppe $R^3$ in $R^3$ = H mit wäßrig-alkalischen Lösungsmitteln ausgewaschen werden. Um hohe thermische Stabilität zu erreichen, ist es zweckmäßig, die Monomeren so auszuwählen, daß die Glastemperatur der Copolymeren oberhalb 100 °C liegt. Die erfindungsgemäßen Polymeren sind hervorragend als Photoresiste geeignet.

Die Hydroxyfunktion ($R^3$ = H) der O-substituierten p-Hydroxystyroleinheiten wird während der Polymerisation durch eine Schutzgruppe blockiert. Diese wird notwendigerweise vor dem Entwicklungsschritt ganz oder teilweise abgespalten. Die Abspaltung der Schutzgruppe kann vor dem Beschichten, beim Prebake oder in einem Postbakeschritt erfolgen.

Zu den das erfindungsgemäße Copolymerisat aufbauenden Komponenten ist im einzelnen folgendes auszuführen.

a) Als o-Nitrocarbinolestermonomere der allgemeinen Formel (I)

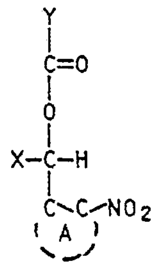

(I)

worin A für ein aromatisches oder heteroaromatisches, gegebenenfalls substituiertes Ringsystem mit 5 bis 14 Ringgliedern,

X für Wasserstoff, einen Alkylrest mit 1 bis 8 Kohlenstoffatomen, einen gegebenenfalls substituierten Aryl- oder Aralkylrest und

Y für einen ethylenisch ungesättigten Rest mit 2 bis 6 Kohlenstoffatomen stehen,

kommen beispielsweise solche in Frage, in denen der Rest Y in der allgemeinen Formel (I) für einen der Reste

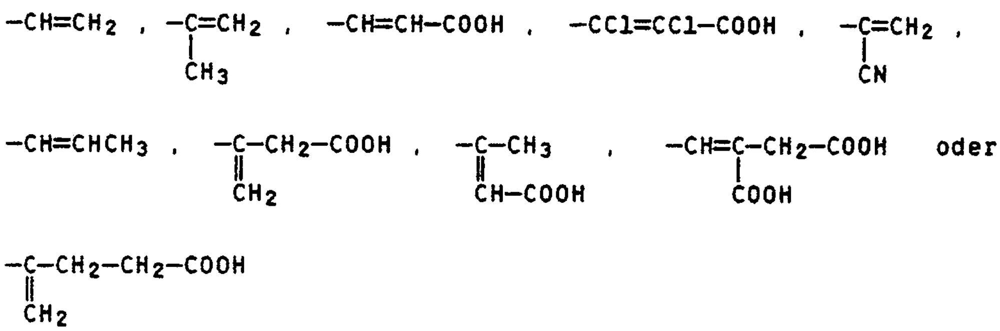

oder

steht.

Dabei werden unter aromatischen Ringsystemen A insbesondere Benzol und substituierte Benzole verstanden. Der Benzolring kann ein- oder mehrfach substituiert sein, beispielsweise durch $C_1$- bis $C_8$-Alkyl, insbesondere Methyl, durch $C_1$- bis $C_6$-Alkoxi, insbesondere Methoxi, durch Halogen, wie Chlor, durch Nitro- oder Aminogruppen sowie durch Sulfogruppen. Es kommen auch entsprechend substituierte und unsubstituierte mehrkernige Benzolderivate, wie Naphthalin, Anthracen, Anthrachinon oder Phenanthren in Betracht. Als heteroaromatisches Ringsystem A ist insbesondere Pyridin zu nennen.

Als den o-Nitrocarbinolestergruppierungen zugrunde liegende aromatische oder heteroaromatische o-Nitrocarbinole haben sich beispielsweise die folgenden Gruppierungen besonders bewährt: o-Nitrobenzyl-, 6-Nitroveratryl-, 2-Nitro-4-aminobenzyl-, 2-Nitro-4-dimethylaminobenzyl-, 2-Nitro-4-methylaminobenzyl-, 2-Nitro-5-dimethylaminobenzyl-, 2-Nitro-5-aminobenzyl-, 2-Nitro-4,6-dimethoxibenzyl-, 2,4-Dinitrobenzyl-, 3-Methyl-2,4-dinitrobenzyl-, 2-Nitro-4-methylbenzyl-, 2,4,6-Trinitrobenzylalkohol sowie 2-Nitrobenzhydrol, 2,2′-Dinitrobenzhydrol, 2,4-Dinitrobenzhydrol oder 2,2′,4,4′-Tetranitrobenzhydrol. Ebenso geeignet sind beispielsweise 2-Nitro-3-hydroximethylnaphthalin, 1-Nitro-2-hydroximethylnaphthalin oder 1-Nitro-2-hydroximethylanthrachinon.

Den erfindungsgemäßen Copolymerisaten liegen, wie oben bereits ausgeführt o-Nitrocarbinolester von olefinisch ungesättigten Carbonsäuren als Monomere zugrunde, wobei als ethylenisch ungesättigte Mono- oder Dicarbonsäuren beispielsweise Acrylsäure, Methacrylsäure, Maleinsäure, Dichlormaleinsäure, Fumarsäure, Crotonsäure, Itaconsäure sowie Methylenglutarsäure verwendet werden können.

Die o-Nitrocarbinolester von olefinisch ungesättigten Carbonsäuren können nach bekannten Methoden der organischen Chemie, wie z.B. Umsetzung der Säurechloride mit o-Nitrocarbinolen oder durch direkte säurekatalyisierte Veresterung hergestellt werden.

Besonders bevorzugte o-Nitrocarbinolestermonomere sind o-Nitrobenzyl-acrylat, o-Nitrobenzyl-methacrylat, o-Nitro-α-methyl-benzyl-(meth)acrylat, 2-Nitro-6-chlor-α-methyl-benzyl-(meth)acrylat.

Die erfindungsgemäßen Copolymerisate enthalten die o-Nitrocarbinolestermonomeren (a) in einer Menge von 5 bis 50, vorzugsweise 10 bis 30 Mol.% einpolymerisiert.

b) Als Comonomere (b) enthalten die erfindungsgemäßen Copolymerisate Verbindungen der allgemeinen Formel (II)

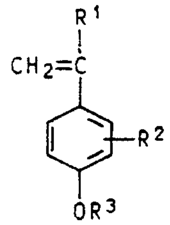

(II)

worin

$R^1$ für Wasserstoff oder eine Methylgruppe,

$R^2$ für Wasserstoff, Halogen, wie z.B. Chlor, oder eine Alkylgruppe mit 1 bis 6 Kohlenstoffatomen,

$R^3$ für Wasserstoff, eine Alkylgruppe mit 1 bis 6 Kohlenstoffatomen, eine Acetyl-, Benzoyl-, $C_1$- bis $C_6$-Alkylsilyl-, $C_1$- bis $C_6$-Alkoxisilyl- oder eine tert.-Butoxicarbonylgruppe

stehen, einpolymerisiert.

Besonders bevorzugte O-substituierte p-Hydroxystyrolderivate sind solche, bei denen die phenolische Hydroxylgruppen verethert oder verestert ist, beispielsweise p-Methoxistyrol, p-Acetoxistyrol oder p-tert.-Butoxicarbonyloxistyrol.

Komponente (b) ist im erfindungsgemäßen Copolymerisat in einer Menge von 95 bis 50, vorzugsweise 90 bis 70 Mol.% einpolymerisiert.

c) Die erfindungsgemäßen Copolymerisate können zur Verbesserung der Löslichkeit in wäßrig-alkalischen Lösungsmitteln oder zur Einstellung anderer Eigenschaften, wie erhöhte thermische Beständigkeit, noch eine oder mehrere von (a) und (b) verschiedene olefinisch ungesättigte, copolymerisierbare organische Verbindungen, deren Homopolymerisate im Wellenlängenbereich zwischen 250 und 400 nm transparent sind, einpolymerisiert enthalten.

Als derartige Comonomere sind beispielsweise geeignet, ethylenisch ungesättigte Carbonsäuren, wie (Meth)acrylsäure, Maleinsäure, Fumarsäure, Crotonsäure, Itaconsäure und/oder Methylenglutarsäure, andere ethylenisch ungesättige Verbindungen, wie Ethylen, Vinylaromaten, wie Styrol, Diene, wie Isopren, Butadien, Ester der bereits genannten olefinisch ungesättigten Carbonsäuren, wie Ester der Acryl- und insbesondere Methacrylsäure mit $C_1$- bis $C_8$-Alkoholen, vorzugsweise Methylmethacrylat sowie andere Derivate der Acrylsäure und/oder Methacrylsäure.

Die Monomeren (c) können in Mengen von 0 bis 30, vorzugsweise 0 bis 20 Mol.% im erfindungsgemäßen Copolymerisat einpolymerisiert sein.

Die Summe der unter (a) bis (c) genannten Molprozentzahlen in den erfindungsgemäßen Copolymeren ist 100.

Beispiele für besonders bevorzugte erfindungsgemäße Copolymerisate sind solche aus o-Nitro-α-methyl-benzylmethacrylat und p-tert.-Butoxicarbonyloxistyrol, o-Nitro-α-methyl-benzylacrylat, p-tert.-Butoxicarbonyloxistyrol und p-Vinylanisol, o-Nitro-α-methyl-benzyl(meth)acrylat, p-tert.-Butoxicarbonyloxistyrol und Methacrylsäure, o-Nitro-α-methyl-benzyl(meth)acrylat, p-tert.-Butoxicarbonyloxistyrol und Acrylsäure sowie solche aus o-Nitro-α-methyl-benzyl(meth)acrylat, p-tert.-Butoxicarbonyloxistyrol und p-Methoxysilyloxistyrol.

Für die Entwickelbarkeit mit wäßrig alkalischen Lösungsmitteln ist es notwendig, daß die substituierten Styrolderivate ganz oder teilweise in p-Hydroxystyrolderivate vor dem Entwickeln der bildmäßig belichteten Bereiche umgewandelt werden. Sowohl die nicht deblockierten Copolymeren, als auch vergleichsweise hergestellte Copolymere aus o-Nitrobenzylacrylaten mit Styrol, gemäß DE-A-21 50 691, lassen sich selbst nach sehr langen Belichtungszeiten mit wäßrig-alkalischen Lösungen nicht richtig entwickeln.

Die erfindungsgemäßen Copolymerisate lassen sich nach verschiedenen bekannten Polymerisationsmethoden aus den jeweiligen Monomeren herstellen. Die Monomeren werden dabei bevorzugt so gewählt, daß die Glastemperatur des resultierenden Copolymeren oberhalb 100 °C liegt. Die Monomeren können dazu beispielsweise in einem geeigneten Lösungsmittel, wie Ethylacetat, Toluol, Aceton, zusammen mit einem Polymerisationsinitiator, wie beispielsweise Benzoylperoxid oder Azo-isobutyronitril, bei Temperaturen im Bereich von 60 bis 120 °C für mehrere Stunden erhitzt werden. Die Reaktion wird dabei zweckmäßigerweise so geführt, daß der Umsatz nicht wesentlich mehr als 50 % beträgt, um eine relativ niedrige Molekulargewichtsverteilung zu erhalten.

Die Molekulargewichte können durch die Polymerisationsbedingungen, wie Reaktionstemperatur, Initiator und Initiatorkonzentration, sowie Lösungsmittel und Monomerkonzentration bestimmt werden. Um Molekulargewichte in dem für die Anwendung als Photoresist günstigen Bereich zwischen 1000 und 500 000 zu erhalten, werden Polymerisationstemperaturen zwischen 60 und 120 °C, Initiatorkonzentrationen zwischen 0,1 Mol.% und 5 Mol.% und Monomerkonzentrationen zwischen 3 % und 50 % bevorzugt. Das Molekulargewicht und die Molekulargewichtsverteilung haben einen großen Einfluß auf die Löslichkeit im jeweiligen Entwickler. Je niedriger das Molekulargewicht und je enger die Molekulargewichtsverteilung, desto besser und einheitlicher ist die Entwickelbarkeit. Bevorzugt sind deshalb Molekulargewichte im Bereich zwischen 1000 und 500 000 g/mol, besonders bevorzugt im Bereich zwischen 5000 und 100 000 g/mol und Molekulargewichtsverteilungen $< 3$.

Die Verwendung der erfindungsgemäßen Copolymerisate ist nicht auf die Anwendung als Photoresist für die Herstellung von Halbleiterbauelementen beschränkt, sondern sie können auch in lichtempfindlichen Beschichtungsmaterialien wie Trockenresisten und Druckplatten verwendet werden. Dazu können noch Zusätze wie Farbstoffe, Pigmente, Sensibilisatoren und andere Zusätze den lichtempfindlichen Materialien zugegeben werden.

Wie erwähnt, sind die erfindungsgemäßen Resiste sehr gut geeignet für die Photolithographie zur Strukturierung von Halbleitern. In solch einem Prozeß werden die Polymeren in geeigneten Lösungsmitteln, z.B. Diethylenglykoldimethylether, Cyclohexanon bzw. Methylcellosolveacetat, gelöst, wobei der Feststoffgehalt im allgemeinen 5 Gew.% bis 30 Gew.% beträgt. Die Lösungen können zweckmäßigerweise durch ein Polytetrafluorethylenfilter (Porendurchmesser ca. 0,2 µm) filtriert werden, und durch z.B. Spincoaten zwischen 1000 und 10 000 U/min können Resistschichten zwischen 0,2 µm und 2,0 µm auf Siliciumwafern aufgebracht werden. Nach dem Ausheizen wird der Film durch eine Quarzmaske im Kontakt- oder Projektionsverfahren belichtet. Die Ausheizbedingungen richten sich jeweils nach dem verwendetem Copolymerisat. Copolymerisate mit t-Butoxicarbonyl-Schutzgruppen werden bevorzugt so behandelt, daß die Schutzgruppe thermisch vor oder nach dem Belichten bei Temperaturen zwischen 160 und 200 °C abgespalten wird. Andere Schutzgruppen werden bevorzugt vor dem Aufbringen des Resists in Lösung abgespalten und das Ausheizen geschieht dann oberhalb der Glastemperatur des jeweiligen Polymeren. Die Belichtung wird solange fortgesetzt, bis die bildmäßig belichteten Teile vollständig entwickelt sind. Als Lichtquellen dienen alternativ Hg-Hochdrucklampen, Cd-Xe-Lampen oder Excimer-Laser im Wellenlängenbereich kleiner 350 nm, bevorzugt 248 nm (KrF). Nach der Belichtung wird der Resist mit wäßrig-alkalischen Entwicklern, wie 2 %ige Tetramethylammoniumhydroxid-Lösung, 1 %ige NaOH, 10 %ige $NaHCO_3$, kommerziellen Positiv-Entwicklern, z.B. Developer S (von Fa. Kodak) oder P4 (von Fa. Merck) entwickelt. Die Entwicklungszeit beträgt in der Regel 30 sec bis 2 Minuten. Sie sollte so gewählt werden, daß der Abtrag in den unbelichteten Bereichen nicht mehr als 5 % beträgt. Der Abtrag der unbelichteten Bereiche im jeweiligen Entwickler wird daneben besonders durch den Gehalt an p-Hydroxistyrol oder anderen wasser- bzw. alkalilöslichen Komponenten im Polymeren beeinflußt.

Um das so erzeugte Resistmuster in das unterliegende Substrat zu übertragen, werden in der Technik sehr häufig Plasmaprozesse angewandt. Eine Beschreibung der Plasmaätztechnik findet man u.a. in "Introduction to Microlithography", ACS Symp. Ser. 219, L.F. Thomson, C.G. Willson, M.J. Bowden, Eds., American Chemical Soc., Washington DC (1983) in Kapitel 5.

Silicium und Siliciumdioxid als Substrate werden im allgemeinen mit fluorhaltigen Plasmen geätzt. Als Plasmareaktoren werden Barrel- und Parallelplattenreaktoren verwandt. Typische Bedingungen für das Ätzen mit fluorhaltigen Gasen, wie $SF_6$, $CF_4$, $CF_4$/6 % $O_2$, im Parallelplattenreaktor sind: Gasdruck zwischen 10 mTorr und 1 Torr, Leistung zwischen 0,11 W/cm$^2$ und 0,66 W/cm$^2$. Die erfindungsgemäßen Polymeren zeigen hervorragende Ätzstabilität gegen fluorhaltige Plasmen mit Abtragsraten zwischen 200 Å/Minute und 700 Å/Minute je nach angewandten Bedingungen.

Die in den folgenden Beispielen genannten Teile und Prozente beziehen sich, soweit nicht anders angegeben, auf das Gewicht.

Beispiel 1

Herstellen der lichtempfindlichen Polymeren

a) Synthese von Copolymeren

10 Teile p-t-Butoxicarbonyloxistyrol (A), hergestellt gemäß der Vorschrift in Polymer, Vol. 24, S. 999 (1983), und 1,2 Teile o-Nitro-α-methylbenzylmethacrylat (B) werden in 10 Volumenteilen Ethylacetat gelöst. Nach Zugabe von 0,082 Teilen Azoisobutyronitril wird 16 Stunden unter Stickstoffatmosphäre auf 70 bis

80 °C erhitzt. Die viskose Lösung wird mit Ethylacetat verdünnt und in Ligroin gefällt. Nach dem Waschen mit Ligroin und Methanol wird das Polymer im Vakuum getrocknet. Die Ausbeute beträgt 6,1 Teile. Im IR-Spektrum sind Carbonylbanden bei 1760 $cm^{-1}$ (Carbonat) und 1720 $cm^{-1}$ (Ester), sowie die Nitrobande bei 1530 $cm^{-1}$ vorhanden.

Weitere Polymere mit unterschiedlichen Zusammensetzungen werden analog der angegebenen Vorschrift hergestellt:

| Monomerzusammensetzung (A) | (B) (Teile) | Initiator Mol.%, bezogen auf Monomere (A) + (B) | Gehalt (B) (%) im Polymer | Reaktionszeit (Stunden) | Ausbeute (%) |
|---|---|---|---|---|---|
| 10 | 14,4 | 1 | 62,0 | 16 | 24 |
| 10 | 7,0 | 1 | 45,3 | 16 | 32 |
| 10 | 2,3 | 1 | 26,6 | 16 | 59 |
| 10 | 1,2 | 1 | 21,8 | 16 | 54 |
| 10 | 0,6 | 1 | 12,0 | 24 | 72 |

b) Synthese von Terpolymeren

10 Teile p-t-Butoxicarbonyloxistyrol (A), 9,4 Teile o-Nitro-α-methylbenzylmethacrylat und 1,3 Teile Methacrylsäure werden in 50 Volumenteilen Ethylacetat gelöst und mit 0,130 Teilen Azoisobutyronitril während 8 Stunden bei 70 bis 80 °C polymerisiert. Nach dem Ausfällen in Ligroin und Trocknen erhält man 7,0 Teile Polymer. Die Titration gegen 0,01 N KOH ergibt einen Methacrylsäuregehalt von 4 %.

Abspalten der Schutzgruppe

c) in Substanz

1,0 g des in Beispiel 1a) hergestellten Copolymeren werden in einem Trockenschrank für 20 Minuten auf 200 °C erhitzt. Der Gewichtsverlust des Polymeren beträgt 0,35 g. NMR und IR-Spektren zeigen, daß die Schutzgruppe vollständig abgespalten ist.

d) in Lösung

1,0 g des in Beispiel 1a) hergestellten Copolymeren werden in 10 ml Dichlormethan gelöst. Nach Zugabe von 0,5 ml Trifluoressigsäure setzt sofort Gasentwicklung ein. Nach Abklingen der Gasentwicklung wird noch 15 Minuten bei Raumtemperatur gerührt und dann in 100 ml Ligroin ausgefällt. NMR und IR-Spektren des gefällten Polymeren zeigen, daß die Schutzgruppe vollständig abgespalten wurde und ein phenolisches Polymer entstanden ist.

Beispiel 2

Herstellen der Resistlösungen, Belichtung und Entwicklung

Poly-(o-nitro-α-methylbenzylmethacrylat-co-p-t-butoxicarbonyloxistyrol) (Mn: 14 000 g/Mol), hergestellt gemäß Beispiel 1a), wird in Diethylenglykoldimethylether zu einer Lösung mit einem Feststoffgehalt von 30 % gelöst. Die Lösung wird durch ein 0,2 µm Teflonfilter filtriert und mit 2450 U/min. auf einem Siliciumwafer aufgeschleudert, wobei eine Schichtdicke von 1 µm resultiert. Der Wafer wird dann 2 Minuten bei 180 °C ausgeheizt und durch eine strukturierte chrombeschichtete Quarzmaske im Kontaktverfahren belichtet. Als Lichtquelle dient ein Excimer Laser der Fa. Lambda Physics, der monochromatisches Licht der Wellenlänge 248 nm aussendet, wenn man mit Krypton und Fluor als Gasmedium arbeitet. Nach der

Belichtung mit 400 $mJ/cm^2$ werden die bildmäßig belichteten Bereiche während 60 Sekunden mit 2 %iger wäßriger Tetramethylammoniumhydroxid-Lösung entwickelt, wobei positive Resiststrukturen guter Qualität entstehen.

Beispiel 3

Ein gemäß Beispiel 1a) hergestelltes Copolymer wird wie in Beispiel 2 gelöst, filtriert und aufgeschleudert. Der Wafer wird dann 2 Minuten bei 130 °C ausgeheizt und belichtet. Direkt nach der Belichtung läßt sich der bildmäßig belichtete Film mit 2 %iger wäßriger Tetramethylammoniumhydroxidlösung nicht entwickeln. Heizt man jedoch direkt nach der Belichtung 2 Minuten bei 180 °C aus, so kann der Resist wie in Beispiel 2 entwickelt werden.

Beispiel 4

Das nach Beispiel 1b) hergestellte Polymere wird 30 %ig in Diethylenglykoldimethylether gelöst und eine 0,8 µm Schicht auf einen Wafer aufgebracht. Es wird 2 min. bei 180 °C ausgeheizt und 4 Sekunden mit dem Excimer Laser bei 248 nm (140 $mJ/cm^2$) belichtet und danach 60 sec. mit einem kommerziellen Entwickler (Developer S der Fa. Kodak) entwickelt. Der Abtrag der unbelichteteten Bereiche beträgt 3 %. Die belichteten Bereiche sind vollständig abgetragen. Strukturen im Submikronbereich sind aufgelöst.

Beispiel 5

Das nach Beispiel 1d) hergestellte Poly-(o-nitro-α-methylbenzylmethacrylat-co-p-hydroxystyrol) wird in Diethylenglykoldimethylether gelöst und filtriert. Von dieser Lösung wird eine 1 µm dicke Polymerschicht auf einen Wafer aufgeschleudert. Der Wafer wird 2 Minuten bei 130 °C ausgeheizt und wie in Beispiel 2 belichtet und entwickelt. Es resultieren ebenfalls Resistbahnen mit guter Strukturqualität.

Beispiel 6

Ermittlung der Plasmaätzbeständigkeit

Die Ätzexperimente werden in einem Parallelplattenreaktor (der Fa. Plasma Technology) durchgeführt. Die zu ätzenden Substrate werden auf der unteren, gekühlten Elektrode positioniert. Zur Erzeugung des Plasmas wird die obere Elektrode an einem 13.56 MHz Hochfrequenzgenerator angeschlossen. Als Ätzgas dient $CF_4$/6 % $O_2$ bei einem Gasdruck von 50 mTorr. Die eingestellte Energie beträgt 0,22 $W/cm^2$. Die Ätzstabilität der gemäß Bespiel 2 hergestellten Resiststrukturen wird im gleichen Prozess verglichen mit der kommerzieller Resiste (Positivresiste auf Novolak- bzw. Polymethylmethacrylat-Basis). Dazu werden jeweils 1 µm dicke Schichten der Polymeren auf Siliciumwafer aufgebracht und die Wafer vor dem Ätzen 2 Minuten bei 200 °C ausgeheizt. Jeweils 5 Wafer wurden auf der unteren Elektrode positioniert, die Kammer evakuiert, Ätzgas eingeleitet und nachdem sich der Druck stabilisiert hat, wird das Plasma gezündet. Die Schichtdicke vor und nach jedem Ätzzyklus wird mit einem α-step-Profilometer gemessen. Es ergeben sich folgenden Abtragsraten:
Polymethylmethacrylat-Resist 960 Å/min
Novolak-Resist 640 Å/min
Beispiel 2 650 Å/min (Strukturen gemäß Beispiel 2)

**Patentansprüche**

**1.** Copolymerisate, die einpolymerisiert enthalten

(a) 5 bis 50 Mol.% mindestens einer Verbindung der allgemeinen Formel (I)

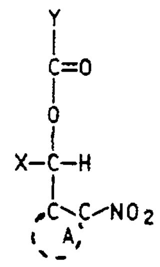

(I)

worin A für ein aromatisches oder heteroaromatisches, gegebenenfalls substituiertes Ringsystem mit 5 bis 14 Ringgliedern,
X für Wasserstoff, einen Alkylrest mit 1 bis 8 Kohlenstoffatomen, einen gegebenenfalls substituierten Aryl- oder Aralkylrest und
Y für einen ethylenisch ungesättigten Rest mit 2 bis 6 Kohlenstoffatomen stehen,
b) 95 bis 50 Mol.% mindestens einer Verbindung der allgemeinen Formel (II)

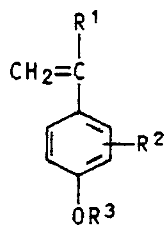

(II)

worin
- $R^1$ für Wasserstoff oder eine Methylgruppe,
- $R^2$ für Wasserstoff, Halogen oder eine Alkylgruppe mit 1 bis 6 Kohlenstoffatomen,
- $R^3$ für Wasserstoff, eine Alkylgruppe mit 1 bis 6 Kohlenstoffatomen, eine Acetyl-, Benzoyl-, $C_1$- bis $C_6$ -Alkylsilyl-, $C_1$- bis $C_6$-Alkoxisilyl- oder eine tert.-Butoxicarbonylgruppe

stehen,
c) 0 bis 30 Mol.% einer oder mehrerer weiterer von (a) und (b) verschiedener olefinisch ungesättigter, copolymerisierbarer organischer Verbindungen, deren Homopolymerisate im Wellenlängenbereich zwischen 250 und 400 nm transparent sind,

mit der Maßgabe, daß die Summe der unter a) bis c) genannten Prozentzahlen 100 ist.

**2.** Copolymerisate nach Anspruch 1, dadurch gekennzeichnet, daß der Rest Y in der allgemeinen Formel (I) für einen der Reste

$-CH=CH_2$ , 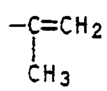 , $-CH=CH-COOH$ , $-CCl=CCl-COOH$ , 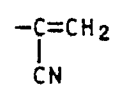 ,

$-CH=CHCH_3$ , 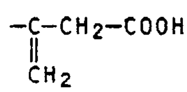 , 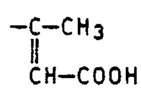 , 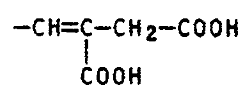 oder

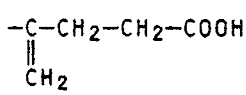

steht.

**3.** Copolymerisate nach Anspruch 1 oder 2, dadurch gekennzeichnet, daß in der allgemeinen Formel (I) der Rest A für Phenyl, der Rest X für Methyl und der Rest Y für eine

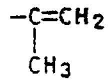

Gruppe steht.

4. Copolymerisate nach einem der vorhergehenden Ansprüche, dadurch gekennzeichnet, daß in der allgemeinen Formel (II) $R^3$ für Wasserstoff, eine Methylgruppe oder eine tert.-Butoxicarbonylgruppe steht.

5. Verfahren zur Herstellung der Copolymerisate nach einem der Ansprüche 1 bis 4, dadurch gekennzeichnet, daß die unter (a) bis (c) genannten Verbindungen in Gegenwart radikalliefernder Initiatoren polymerisiert werden, mit der Maßgabe, daß $R^3$ der Komponente (b) für eine Alkylgruppe mit 1 bis 6 Kohlenstoffatomen, eine Acetyl-, Benzoyl-, $C_1$- bis $C_6$-Alkylsilyl-, $C_1$- bis $C_6$-Alkoxisilyl- oder eine tert.-Butoxicarbonylgruppe steht, und das erhaltene Copolymerisat gegebenenfalls in das Copolymerisat mit $R^3$ = H überführt wird.

6. Wäßrig-alkalisch auswaschbare Photoresiste, dadurch gekennzeichnet, daß sie Copolymerisate nach einem der Ansprüche 1 bis 4 enthalten.

7. Verfahren zur Herstellung von Halbleiterbauelementen, dadurch gekennzeichnet, daß man Copolymerisate nach einem der Ansprüche 1 bis 4 als lichtempfindliche Materialien verwendet.

8. Verwendung der Copolymerisate nach einem der Ansprüche 1 bis 4 in lichtempfindlichen Beschichtungsmaterialien.

9. Verwendung der Copolymerisate nach einem der Ansprüche 1 bis 4 zur Herstellung von Trockenresisten.

10. Verwendung der Copolymerisate nach einem der Ansprüche 1 bis 4 für Flachdruckplatten.

11. Verwendung der Copolymerisate nach einem der Ansprüche 1 bis 4 als Photoätzgrund.

## Claims

1. A copolymer which contains as copolymerized units
(a) from 5 to 50 mol % of one or more compounds of the general formula (I)

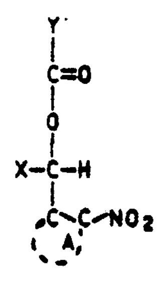

where A is an aromatic or heteroaromatic, substituted or unsubstituted ring system of 5 to 14 ring members, X is hydrogen, alkyl of 1 to 8 carbon atoms, or substituted or unsubstituted aryl or aralkyl, and Y is an ethylenically unsaturated radical of 2 to 6 carbon atoms,
(b) from 95 to 50 mol % of one or more compounds of the general formula (II)

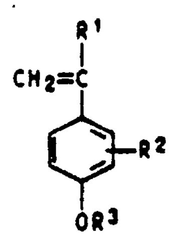

where $R^1$ is hydrogen or methyl, $R^2$ is hydrogen, halogen or alkyl of 1 to 6 carbon atoms, $R^3$ is hydrogen, alkyl of 1 to 6 carbon atoms, acetyl, benzoyl, $C_1$-$C_6$-alkylsilyl, $C_1$-$C_6$-alkoxysilyl or tert.-butoxycarbonyl, and

(c) from 0 to 30 mol % of one or more further olefinically unsaturated, copolymerizable organic compounds, other than (a) and (b), whose homopolymers are transparent within the wavelength region from 250 to 400 nm,

with the proviso that the percentages mentioned under (a) to (c) add up to 100.

**2.** A copolymer as claimed in claim 1, wherein the radical Y in the general formula (I) is one of the radicals

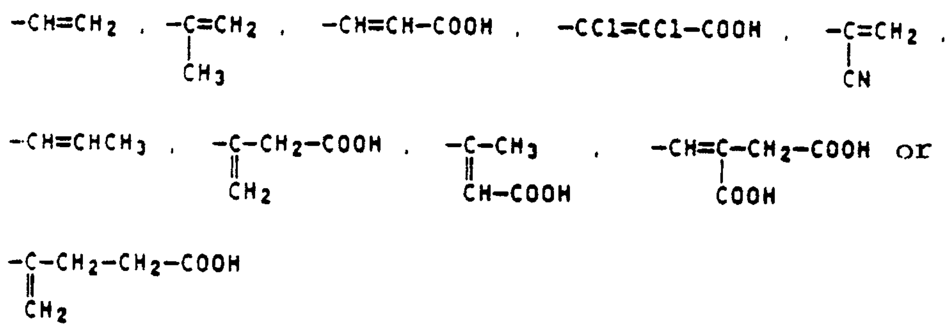

**3.** A copolymer as claimed in claim 1 or 2, wherein in the general formula (I) the radical A is phenyl, the radical x is methyl and the radical Y is a

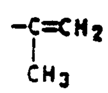

group.

**4.** A copolymer as claimed in any one of the preceding claims, wherein in the general formula (II) $R^3$ is hydrogen, methyl or tert.-butoxycarbonyl.

**5.** A process for preparing a copolymer as claimed in any one of claims 1 to 4, which comprises polymerizing the compounds mentioned under (a) to (c) in the presence of a free radical initiator, with the proviso that $R^3$ of component (b) is alkyl of 1 to 6 carbon atoms, acetyl, benzoyl, $C_1$-$C_6$-alkylsilyl, $C_1$-$C_6$-alkoxysilyl or tert.-butoxycarbonyl, and if appropriate converting the copolymer obtained into the copolymer where $R^3$ is H.

**6.** A photoresist which can be washed out with an aqueous alkaline solution, containing a copolymer as claimed in any one of claims 1 to 4.

7. A process for producing semiconductor elements, which comprises using a copolymer as claimed in any one of claims 1 to 4 as a light-sensitive material.

8. Use of a copolymer as claimed in any one of claims 1 to 4 in a light-sensitive coating material.

9. Use of a copolymer as claimed in any one of claims 1 to 4 for producing a dry resist.

10. Use of a copolymer as claimed in any one of claims 1 to 4 for planographic printing plates.

11. Use of a copolymer as claimed in any of claims 1 to 4 as a resist.

**Revendications**

1. Copolymérisats qui contiennent en polymérisation

a) 5 à 50 moi % d'au moins un composé de la formule générale (I)

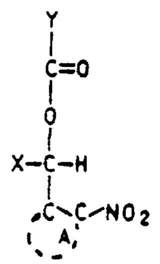

(I)

où A est mis pour un système cyclique, aromatique ou hétéroaromatique, éventuellement substitué, de 5 à 14 chainons
X pour hydrogène, un reste alkyle de 1 à 5 atomes de carbone, un reste aryle ou aralkyle éventuellement substitué et
Y pour un reste insaturé éthyléniquement de 2 à 6 atomes de carbone
b) 95 à 50 moi % d'au moins un composé de la formule générale (II)

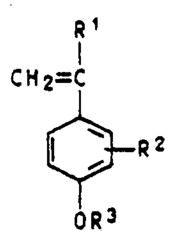

(II)

dans laquelle
$R^1$ est mis pour hydrogène ou un groupe méthyle
$R^2$ pour hydrogène, halogène ou un groupe alkyle de 1 à 6 atomes de carbone
$R^3$ pour hydrogène, un groupe alkyle de 1 à 6 atomes de carbone, un groupe acetyle, benzoyle, (alkyle en C 1-C 6)-silyle, (alcoxy en C 1- C 6)-silyle ou tert-butoxycarbonyle
c) 0 à 30 mol % d'un ou plusieurs autres composés organiques, copolymérisables, insaturés oléfiniquement, différents de a) et b), dont les homopolymérisats sont transparents dans le domaine des longueurs d'ondes comprises entre 250 à 400 nm à condition que la somme des pourcentages indiqués sous a) à c) soit égale à 100.

2. Copolymérisats selon la revendication 1, caractérisé par le fait que le reste Y dans la formule générale (I) est mis pour un des restes

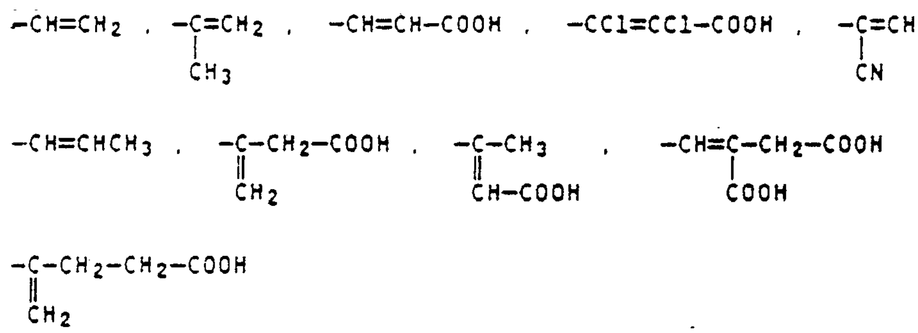

ou :

3. Copolymérisats selon la revendication 1 ou 2, caractérisé par le fait que, dans la formule générale (I), le reste A est mis pour phenyle, les reste x pour methyle et le reste Y pour un groupe

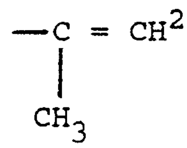

4. Copolymérisats selon l'une des revendications précédentes caractérisé par le fait que, dans la formule générale (II), $R^3$ est mis pour hydrogène, un groupe méthyle ou un groupe tert-butoxycarbonyle.

5. Procédé de préparation des copolymérisats selon l'une des revendications 1 à 4, caractérisé par le fait que les composés indiqués sous a) à c) sont polymérisés en présence d'initiateurs fournissant des radicaux, avec la condition que $R^3$ des composants (b) soit mis pour un groupe alkyle de 1 à 6 atomes C, un groupe acetyle, benzoyle, (alkyle-C 1-C 6)-silyle, (alcoxy en C 1-C 6)-silyle, ou tert-butoxycarbonyle, et le copolymérisat obtenu est transformé éventuellement en le copolymérisat où $R^3$ = H.

6. Photo-réserves enlevées par lavage aqueux-alcalin, caractérisé par le fait qu'elles contiennent des copolymérisats selon l'une des revendications 1 à 4.

7. Procédé de préparation d'éléments semi-conducteurs caractérisé par le fait qu'on utilise comme matériaux sensibles à la lumière des copolymérisats selon l'une des revendications 1 à 4.

8. Utilisation des copolymérisats selon l'une des revendications 1 à 4 dans des matériaux de revêtement sensibles à la lumière.

9. Utilisation des copolymérisats selon l'une des revendications 1 à 4 pour la fabrication de réserves sèches.

10. Utilisation des copolymérisats selon l'une des revendications 1 à 4 pour les plaques d'impression.

11. Utilisation des copolymérisats selon l'une des revendications 1 à 4 comme base de photogravure.